# EUROPEAN PATENT APPLICATION

(11) **EP 2 234 176 A2**
(43) Date of publication of application: **29.09.2010**
(21) Application number: 10250538.5
(22) Date of filing: 22.03.2010
(51) Int. Cl.: H01L 31/048

(54) **Solar cell module**

(30) Priority: 23.03.2009 JP 2009070354
(71) Applicant: Sanyo Electric Co., Ltd., Osaka 570-8677 (JP)
(72) Inventor: Kadonaga, Yasuo, Moriguchi City, Osaka 570-9677 (JP)
(74) Representative: Calderbank, Thomas Roger

(57) **Abstract**

In the solar cell module 100, the insulating sheet 15 has the slit 151 which is in contact with the output lead 12 inside the opening portion 141 of the rear-surface-side protection member 14.

## Description

The present invention relates to a solar cell module including an output lead configured to draw electric power from the solar cell.

A solar cell is expected as a new energy source because the solar cell directly converts clean and inexhaustibly supplied sunlight into electricity. Generally, in order to increase the weather resistance of a solar cell, the solar cell is sealed with a sealing member between a Eght-receiving-surface-side protection member and a rear-surface-side protection member. As the rear-surface-side protection member, a laminated film in which a metal layer such as aluminum layer is sandwiched between resin layers is also widely used to improve the moisture resistance thereof.

Electric power generated by such solar cell is drawn to the outside of the solar cell module by an output lead connected to the solar cell. Specifically, the output lead is drawn out to the outside of the solar cell module through an opening portion formed in the rear-surface-side protection member.

In this process, a technique has been proposed to cover a part of the metal layer with an insulating film and draw the output lead along the insulating film (refer to Japanese Utility Model Registration Application Publication No. Hei 3-63954). According to this technique, electrical insulation between the metal layer exposed to the opening portion and the output lead can be improved.

However, with the technique described in Japanese Utility Model Registration Application Publication No. Hei 3-63954, the metal layer exposed in the opening portion and the output lead are adjacent to each other with the insulating firm interposed therebetween. Thus, the electrical insulation may not be secured if the solar cell module has a high output.

The invention is made in view of the above-mentioned problem, and it is an object of the invention to provide a solar cell module capable of securing electrical insulation between a metal layer of a rear-surface-side protection member and an output lead.

An aspect of the present invention is summarized as a solar cell module comprising: a solar cell having a light receiving surface and a rear surface provided on the opposite side to the light receiving surface; an output lead configured to draw electric power from the solar cell; a light-receiving-surface-side protection member disposed on the light-receiving-surface-side of the solar cell; a rear-surface-side protection member disposed on the rear-surface-side of the solar cell and having an opening portion through which the output lead is drawn out; and an insulating sheet disposed on the opening portion; and wherein the rear-surface-side protection member includes a metal layer sandwiched between a plurality of resin layers, and the insulating sheet includes a contact portion which is in contact with the output lead inside the opening portion in a plan view.

In the above aspect of the present invention, it is preferable that the insulating sheet is formed of a pair of sheets sandwiching the rear-surface-side protection member, and the contact portion is a slit formed in the insulating sheet.

In the above aspect of the present invention, it is preferable that the insulating sheet covers the opening portion at the solar cell side of the rear-surface-side protection member.

In the above aspect of the present invention, it is preferable that the insulating sheet covers the opening portion at the opposite side of the rear-surface-side protection member to the solar cell.

In the above aspect of the present invention, it is preferable that a distance between an outer edge of the insulating sheet and an outer edge of the opening portion is greater than a thickness of the rear-surface-side protection member.

### In the drawings:

Fig. 1 is a side view of a solar cell module 100 according to a first embodiment of the invention.
Fig. 2 is a plan view from the rear-surface-side protection member 14 of the solar cell module 100 according to the embodiment of the invention.
Fig. 3 is a cross-sectional view taken along the line A-A of Fig. 2.
Fig. 4 is an exploded cross-sectional view illustrating a manufacturing method of the solar cell module 100 according to the embodiment of the invention.
Figs. 5A and 5B are a plan view and a cross-sectional view illustrating the configuration of an insulating sheet 20 according to the embodiment of the invention, respectively.

Next, the embodiments of the invention are described with reference to the drawings. In the following description of the drawings, identical or similar reference numerals are assigned to identical or similar components. However, the drawings are schematic, thus it should be noted that the dimensions are not shown to scale. Accordingly specific dimensions should be recognized in consideration of the following description. Also, there are inevitably included some portions of the drawings between which a dimensional relationship and/or a scale are inconsistent.

### [Schematic Configuration of Solar Cell Module]

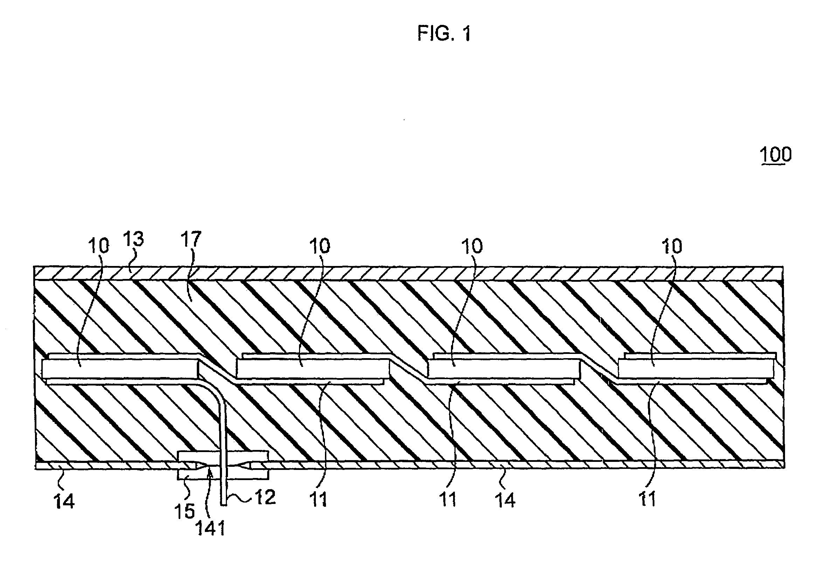

The schematic configuration of a solar cell module 100 according to an embodiment of the invention is described with reference to Fig. 1. Fig. 1 is a side view of the solar cell module 100 according to the embodiment of the invention.

As shown in Fig. 1, the solar cell module 100 includes plurality of solar cells 10, a plurality of connecting members 11, an output lead 12, a light-receiving-surface-side protection member 13, a rear-surface-side protection member 14, an insulating sheet 15, and a sealing member 17. The solar cell module 100 is formed by sealing the plurality of solar cells 10 between the light-receiving-surface-side protection member 13 and the rear-surface-side protection member 14.

The plurality of solar cells 10 are arranged in a matrix form between the light-receiving-surface-side protection member 13 and the rear-surface-side protection member 14. The plurality of solar cells 10 are electrically connected by the plurality of connecting members 11. Each solar cell 10 has a light receiving surface configured to receive light and a rear surface provided on the opposite side of the solar cell 10 to the light receiving surface. Although not shown, there are provided in each solar cell 10, a photoelectric conversion part configured to generate a carrier by receiving light on the light receiving surface, and a pair of positive and negative electrodes configured to draw the career from the photoelectric conversion part.

Each of the plurality of connecting members 11 is connected to an electrode formed on the light receiving surface of one solar cell 10, and an electrode formed on the rear surface of another solar cell 10 adjacent to the one solar cell 10. Thereby, the one solar cell 10 and the other solar cell 10 are electrically connected to each other. Each connecting member 11 is preferably formed of a thin plate or a twisted wire of a material having a low electrical resistance such as copper, silver, gold, tin, nickel, aluminum, or an alloy of these. The surface of each connecting member 11 may be formed with a conductive material such as lead-free solder (e.g., SnAg_{3.0}Cu_{0.5} solder).

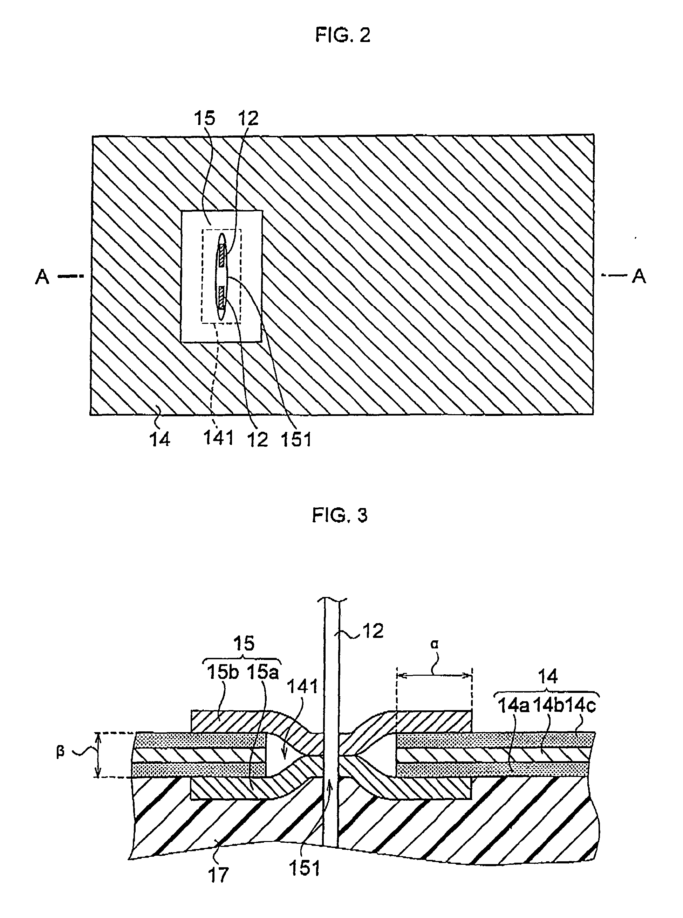

The output lead 12 is a wiring member configured to draw the electric power generated by the plurality of solar cells 10 to the outside thereof. One end of the output lead 12 is electrically connected to an electrode of at least one solar cell 10. The other end of the output lead 12 is inserted through an insulating sheet 15 disposed on an opening portion 141, and is connected to a connecting terminal in an unillustrated terminal box. Although not shown, a pair of positive and negative output leads is generally provided in the solar cell module 100 (not shown in Fig. 1, see Fig. 2).

Similarly to the connecting member 11, the output lead 12 is preferably formed of a material having a low electrical resistance. Also, the output lead 12 is covered with an insulating film.

The light-receiving-surface-side protection member 13 is disposed on the light-receiving-surface-side of a plurality of solar cells 10. The light-receiving-surface-side protection member 13 protects the surface of the solar cell module 100. As the light-receiving--surface-side protection member 13, a glass which has a translucency and an imperviousness to water or a translucent plastic may be used.

The rear-surface-side protection member 14 is disposed on the rear-surface-side of the plurality of solar cells 10. The rear-surface-side protection member 14 protects the rear surface of the solar cell module 100. The rear-surface-side protection member 14 according to the embodiment has a structure in which a metal layer is sandwiched between two resin layers. The rear-surface-side protection member 14 has the opening portion 141 through which the other end of the output lead 12 is drawn out to the outside of the solar cell module.

The insulating sheet 15 is disposed at the opening portion 141 of the rear-surface-side protection member 14. In the embodiment, the insulating sheet 15 is formed of a pair of sheets sandwiching the rear-surface-side protection member 14, and covers both sides of the opening portion 141. The output lead 12 is inserted through the insulating sheet 15.

The sealing member 17 seals the plurality of solar cells 10 between the light-receiving-surface-side protection member 13 and the rear-surface-side protection member 14. As the sealing member 17, translucent resin such as EVA, EEA, PVB, silicon, urethane, acryl, and epoxy may be used.

An Al frame may be mounted on the outer circumference of the solar cell module 100 which has the above configuration.

### [Configuration of Rear Surface Side Protection Member and Insulating Sheet]

Next, the configurations of the rear-surface-side protection member 14 and the insulating sheet 15 are described with reference to Figs. 2 and 3.

Fig. 2 is a plan view from the rear-surface-side protection member 14 of the solar cell module 100 according to the embodiment of the invention. Fig. 3 is a cross-sectional view taken along the line A-A of Fig. 2.

As shown in Fig. 2, the opening portion 141 of the rear-surface-side protection member 14 is covered with the insulating sheet 15. At the insulating sheet 15, there is formed a slit 151, through which a pair of the output leads 12 are drawn out.

The slit 151 is in contact with the pair of output leads 12. The slit 151 is formed inside the opening portion 141 in the plan view. Accordingly, the base portion of the pair of output leads 12 is fixed within the opening portion 141 by contacting against the slit 151. It should be noted that the slit 151 is the "contact portion" according to the invention.

As shown in Fig. 3, the rear-surface-side protection member 14 is formed of a first resin layer 14a, a metal layer 14b, and a second resin layer 14c. The metal layer 14b is sandwiched between the first resin layer 14a and the second resin layer 14c. The first resin layer 14a and the second resin layer 14c are sheet-like resin films such as a PET film, for example. The metal layer 14b is an aluminum foil, for example. The metal layer 14b is exposed on the inwall of the opening portion 141.

As shown in Fig. 3, the insulating sheet 15 according to the embodiment is formed of a pair of a first sheet 15a and a second sheet 15b.

The first sheet 15a covers the opening portion 141 at the solar cell 10 side of the rear-surface-side protection member 14. The second sheet 15b covers the opening portion 141 at the opposite side of the rear-surface-side protection member 14 to the solar cell 10. The first sheet 15a and the second sheet 15b may be in direct contact with respective surfaces of the rear-surface-side protection member 14.

As each of the first sheet 15a and the second sheet 15b, an insulating resin sheet or a rubber sheet may be used, for example. Although the first sheet 15a and the second sheet 15b need not to be elastic, but preferably have moderate flexibility.

The first sheet 15a and the second sheet 15b are connected to each other inside the opening portion 141. The slit 151 is formed in the connecting portion between the first sheet 15a and the second sheet 15b of the insulating sheet 15.

Specifically, the slit 151 is spaced away from the inwall of the opening portion 141 as shown in Figs. 2 and 3. That is, the slit 151 is formed inside the opening portion 141, and is spaced away from the metal layer 14b exposed on the inwall of the opening portion 141. Thus, the output leads 12 inserted through the slit 151 are fixed to a position spaced away from the metal layer 14b.

In the embodiment, it should be noted that the distance α between the outer edge of the insulating sheet 15 and the outer edge of the opening portion 141 is greater than the thickness β of the rear-surface-side protection member 14 as shown in Fig. 3.

### [Manufacturing Method of Solar Cell Module]

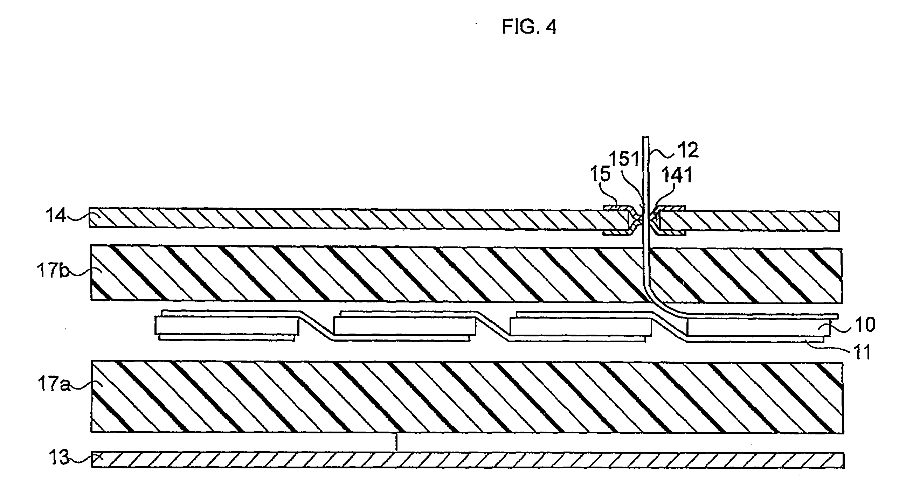

Next, a manufacturing method of the solar cell module 100 is described with reference to the drawings. Fig. 4 is an exploded sectional view of the solar cell module 100 before it is modularized.

First, the plurality of solar cells 10 arranged in a matrix form are electrically connected with the connecting member 11.

Next, one end of the output lead 12 is electrically connected to at least one solar cell 10.

Next, a slit is formed through the sealing member 17b in the thickness direction for the output lead 12 to be inserted through the slit.

Next, the opening portion 141 is formed in the rear-surface-side protection member 14 by removing a portion thereof.

Next, respective center portions of the first sheet 15a and the second sheet 15b are bonded to each other. The slit 151 is then formed by making a linear cut at the connecting portion between the first sheet 15a and the second sheet 15b. Thus, the insulating sheet 15 is prepared.

Next, the insulating sheet 15 is fitted into the opening portion 141 so as to sandwich the rear-surface-side protection member 14 by the first sheet 15a and the second sheet 15b.

Next, a laminated body is formed by sequentially laminating the light-receiving-surface-side protection member 13, the sealing member 17a, the plurality of solar cells 10, the sealing member 17b, and the rear-surface-side protection member 14. In this step, as shown in Fig. 4, the output lead 12 is drawn out through the slit of sealing member 17b and the slit 151 of the insulating sheet 15.

Next, the laminated body is heated in a predetermined condition in a vacuum atmosphere. Thereby, the sealing member 17 is cured.

### [Operation and Effect]

In the solar cell module 100 according to the embodiment, the insulating sheet 15 has the slit 151 which is in contact with the output lead 12 inside the opening portion 141 of the rear-surface-side protection member 14.

Accordingly, the base portion of the output lead 12 is fixed within the opening portion 141 by contacting against the slit 151. Thus, the output lead 12 can be spaced away from the metal layer 14b exposed on the inwall of the opening portion 141. As a result, the electrical insulation between the output lead 12 and the metal layer 14b can be secured, thus, reduction in insulation performance of the solar cell module can be prevented.

In the solar cell module 100 according to the embodiment, the first sheet 15a covers the opening portion 141 at the solar cell 10 side of the roar-surface-side protection member 14. Thus, even if the output lead 12 is drawn along the rear-surface-side protection member 14 inside the solar cell module 100, contact of the output lead 12 with the metal layer 14b can be avoided. Accordingly, a degree of freedom of arrangement of the output lead 12 can be improved. Also, permeation of water into the solar cell module 100 can be prevented by the first sheet 15a.

In the solar cell module 100 according to the embodiment, the second sheet 15b covers the opening portion 141 at the opposite side of the rear-surface-side protection member 14 to the solar cell 10. Thus, even if the output lead 12 is turned back outside the solar cell module 100, contact of the output lead 12 with the metal layer 14b can be avoided. Also, permeation of water into the solar cell module 100 can be prevented by the second sheet 15b.

### [Other Embodiments]

Although the invention has been described according to the above embodiments, it should be understood that the discussion and drawings which form part of the disclosure are not intended to limit the invention. Various alternative embodiments, implementation examples, and application technique will be apparent to those skilled in the art.

For example, in the embodiment described above, the insulating sheet 15 is formed of the pair of the first sheet 15a and the second sheet 15b, however; the invention is not limited to this configuration. For example, the insulating sheet 15 may be formed of either one of the pair of the first sheet 15a and the second sheet 15b. Even in this case, the output lead 12 can be spaced away from the metal layer 14b exposed on the inwall of the opening portion 141 by forming the slit 151 in one of the sheets.

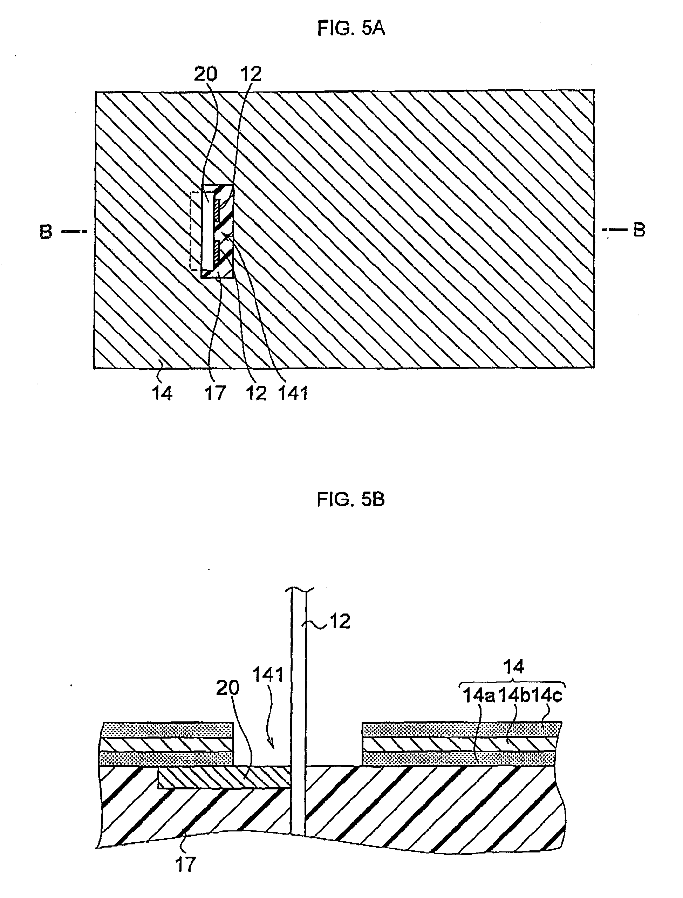

In the embodiment described above, as an example of a contact portion according to the invention, the slit 151 formed in the insulating sheet 15 has been described; however, the invention is not limited to this configuration. At a contact portion according to the invention, the base portion of the output leads 12 is only needs to be fixed to a position spaced away from the metal layer 14b exposed on the inwall of the opening portion 141. Thus, the insulating sheet 20 does not need to cover the opening portion 141. Specifically, as shown in Figs. 5A and 5B, one end of the insulating sheet 20 may be located between the rear-surface-side protection member 14 and the sealing member 17, and the other end of the insulating sheet 15 may be located near the center of the opening portion 141 in a plan view. The base portion of the output leads 12 is fixed to a position by contacting the base portion against the other end of the insulating sheet 20. In this case, the other end of the insulating sheet 20 corresponds to a contact portion of the invention. The insulating sheet 20 may not be inserted between the rear-surface-side protection member 14 and the sealing member 17, and may be bonded on the surface of the rear-surface-side protection member 14.

In the embodiment described above, one example has been used to describe the configuration of the solar cell module; however, the invention is not limited to this configuration. For example, the solar cell module 100 may be provided with thin-film solar cells laminated on the light-receiving-surface-side protection member 13 in replace of crystalline solar cells 10 described above.

Although the following has not been mentioned in the embodiment described above, a wiring member for bypass diode connection may be drawn out along with the output lead 12 from the slit 151.

In the embodiment described above, the rear-surface-side protection member 14 has a configuration in which the metal layer is sandwiched between two resin layers; however the invention is not limited to this configuration. For example, the rear-surface-side protection member 14 may have three or more resin layers and may have two or more metal layers.

Thus, it should be understood that the invention includes various embodiments not specifically described herein. Accordingly, the technical scope of the invention should be defined only by the specifications of the invention according to the claims based on the above description, interpreted with reference to the drawings.

## Claims

1. A solar cell module comprising:
a solar cell having a light receiving surface and a rear surface provided on the opposite side to the light receiving surface;
a output lead configured to draw electric power from the solar cell;
a light-receiving-surface-side protection member disposed on the light-receiving-surface-side of the solar cell;
a rear-surface-side protection member disposed on the rear-surface-side of the solar cell and having an opening portion through which the output lead is drawn out; and
an insulating sheet disposed on the opening portion; and wherein
the rear-surface-side protection member includes a metal layer sandwiched between a plurality of resin layers, and
the insulating sheet includes a contact portion which is in contact with the output lead inside the opening portion in a plan view.

2. The solar cell module according to claim 1, wherein
the insulating sheet is formed of a pair of sheets sandwiching the rear-surface-side protection member, and
the contact portion is a slit formed in the insulating sheet.

3. The solar cell module according to claim 1, wherein the insulating sheet covers the opening portion at the solar cell side of the rear-surface-side protection member.

4. The solar cell module according to claim 1, wherein the insulating sheet covers the opening portion at the opposite side of the rear-surface-side protection member to the solar cell.

5. The solar cell module according to claim 4, wherein a distance between an outer edge of the insulating sheet and an outer edge of the opening portion is greater than a thickness of the rear-surface-side protection member.
